(19) **Europäisches Patentamt**
**European Patent Office**
**Office européen des brevets**

(11) **EP 3 907 840 A1**

(12) **EUROPÄISCHE PATENTANMELDUNG**

(43) Veröffentlichungstag:
 **10.11.2021 Patentblatt 2021/45**

(51) Int Cl.:
 **H02H 9/08** (2006.01)

(21) Anmeldenummer: **20173634.5**

(22) Anmeldetag: **08.05.2020**

(84) Benannte Vertragsstaaten:
 **AL AT BE BG CH CY CZ DE DK EE ES FI FR GB GR HR HU IE IS IT LI LT LU LV MC MK MT NL NO PL PT RO RS SE SI SK SM TR**
 Benannte Erstreckungsstaaten:
 **BA ME**
 Benannte Validierungsstaaten:
 **KH MA MD TN**

(71) Anmelder: **Siemens Aktiengesellschaft**
 **80333 München (DE)**

(72) Erfinder:
 • **Schinerl, Thomas**
  **4063 Hörsching (AT)**
 • **Aigner, Florian**
  **4311 Schwertberg (AT)**
 • **Schuster, Hannes**
  **4614 Marchtrenk (AT)**

(74) Vertreter: **Maier, Daniel Oliver**
 **Siemens AG**
 **Postfach 22 16 34**
 **80506 München (DE)**

(54) **VERFAHREN UND VORRICHTUNG ZUR KOMPENSATION EINER AUF EINEM DREIPHASIGEN SPANNUNGSVERSORGUNGSNETZ AUFTRETENDEN LEITUNGSSTÖRUNG**

(57) Vorrichtung zur Kompensation einer auf einem dreiphasigen Spannungsversorgungsnetz auftretenden Leitungsstörung ($I_f$), umfassend einen Transformator ($T$) mit einem Sternpunkt, welcher dazu eingerichtet ist, eine Netzspannung ($U_{L1e}$, $U_{L2e}$, $U_{L3e}$) und dadurch eine Verlagerungsspannung ($U_0$) zu erzeugen, und ferner eine Mess- und Steuervorrichtung (1) vorgesehen ist, welche dazu eingerichtet ist, die Netzspannung ($U_{L1e}$, $U_{L2e}$, $U_{L3e}$) oder die Verlagerungsspannung ($U_0$) zu erfassen und dabei eine auftretende Leitungsstörung ($I_f$) zu erkennen und eine Steuergröße zur Kompensation der Leitungsstörung zu bestimmen, und ferner eine Umrichter-Schaltung (2) vorgesehen ist, welche dazu eingerichtet ist, aus der Steuergröße einen Steuerstrom ($I_{comp}$) zu erzeugen und zur Kompensation der Leitungsstörung ($I_f$) im Sternpunkt des Transformators ($T$) einzuspeisen, wobei die Mess- und Steuervorrichtung (1) ferner dazu eingerichtet ist, einen Boost-Leitwert ($Y_{Boost}$) zu bestimmen, daraus eine Boost-Funktion zu ermitteln, einen entsprechenden Boost-Strom ($I_{Boost}$) zu erzeugen und im Sternpunkt des Transformators ($T$) einzuspeisen.

FIG 2

EP 3 907 840 A1

**Beschreibung**

Die Erfindung betrifft ein Verfahren und eine Vorrichtung zur Kompensation einer auf einem dreiphasigen Spannungsversorgungsnetz auftretenden Leitungsstörung, umfassend einen Transformator mit einem Sternpunkt, welcher dazu eingerichtet ist, eine Netzspannung und dadurch eine Verlagerungsspannung zu erzeugen, und ferner eine Mess- und Steuervorrichtung vorgesehen ist, welche dazu eingerichtet ist, die Netzspannung oder die Verlagerungsspannung zu erfassen und dabei eine auftretende Leitungsstörung zu erkennen und eine Steuergröße zur Kompensation der Leitungsstörung zu bestimmen, und ferner eine Umrichter-Schaltung vorgesehen ist, welche dazu eingerichtet ist, aus der Steuergröße einen Steuerstrom zu erzeugen und zur Kompensation der Leitungsstörung im Sternpunkt des Transformators einzuspeisen.

Es ist bekannt, dass eine Leitungsstörung beispielsweise durch eine Überwachung der Netzspannungen der einzelnen Phasen, und bei Unterschreiten eines vorgegebenen Grenzwerts, wie beispielsweise eine Unterschreitung der Netzspannung in einer Phase unter 50% der regulären Netzspannung im Normalbetrieb, oder eine Überschreitung der Netzspannung über 100% der regulären Netzspannung, erkannt werden kann.

Außerdem kann eine Leitungsstörung durch eine Überwachung der Verlagerungsspannung im Sternpunkt des Drei-Phasennetzes bei Überschreiten eines vorgegebenen Grenzwerts erkannt werden.

Ferner kann eine Leitungsstörung auch durch eine Bestimmung einer aus der Netzspannung oder Verlagerungsspannung abgeleiteten Größe, wie beispielsweise eines Fehlerwiderstandes in der relevanten Phase des Drei-Phasennetzes erkannt werden.

Es ist klar, dass bei einer Leitungsstörung auch die zugehörige Phase festgestellt werden kann.

Als niederohmige Erdschlüsse werden in der Technik allgemein Erdschlüsse mit einem Erdübergangswiderstand von weniger als 5 kΩ bezeichnet, insbesondere solche mit einem Erdübergangswiderstand von weniger als 1 kΩ.

Hochohmige Erdschlusse können beispielsweise auftreten, wenn ein umgestürzter Baum eine Leitung berührt (40 bis 100 kΩ), ein Leiterseil nach einem Seilriss auf trockenen Sand, trockenen Felsen, Schnee oder Eis fällt, oder bei einem rückwärtigen Kabelbruch, bei welchem ein vom Verbraucher rückkehrendes Leiterseil sich niederohmig der Erde nähert oder gar diese berührt.

In der Praxis ist es möglich, dass durch derartige Erdschlüsse an abgelegenen Orten beispielsweise Waldbrände entstehen können und folgenschwere Schäden anrichten.

In kompensierten Netzen wird eine Erdschlusslöschspule (Petersen Spule) dazu verwendet, kapazitive Erdfehlerströme von Abgängen mit einem induktiven Strom zu kompensieren.

Dennoch können auch bei idealer Einstellung der Erdschlusslöschspule der durch die Netzverluste entstehende Wirkanteil im Fehlerstrom nicht kompensiert werden.

Es ist daher eine Aufgabe der Erfindung Fehlerströme nach einem entsprechenden Fehlerereignis schneller und effizienter zu kompensieren.

Die Aufgabe wird durch eine Vorrichtung eingangs genannter Art gelöst, indem die Mess- und Steuervorrichtung ferner dazu eingerichtet ist, einen Boost-Leitwert zu bestimmen, daraus eine Boost-Funktion zu ermitteln, einen entsprechenden Boost-Strom zu erzeugen und im Sternpunkt des Transformators einzuspeisen.

Mit anderen Worten umfasst die Steuergröße zusätzlich eine Boost-Funktion, welche auf einem Boost-Leitwert basiert, welcher von der Mess- und Steuervorrichtung zuvor bestimmt wird.

Durch die Erfindung wird erreicht, dass im Sinne einer aktiven Reststromkompensation ein Kompensationsstrom in den Sternpunkt eines Verteiltransformators eingespeist wird, welcher dem Fehlerstrom entgegenwirkt und reduziert.

Durch die Boost-Funktion kann erreicht werden, dass die Kompensation eines Fehlerstrom erheblich rascher erfolgt und somit entsprechende Anforderungen von Netzbetreibern erfüllt werden können.

Der Fehlerwiderstand kann durch die Lage des Sternpunkts im dreiphasigen Mittel- oder Hochspannungsnetz ermittelt werden.

In einer Weiterbildung der Erfindung ist es vorgesehen, dass die Boost-Funktion ein Maximum von 20%, bevorzugt 50%, besonders bevorzugt 100% oder 200% des Betrags des Maximums des Effektivwerts der Steuergröße aufweist.

Dadurch kann die Kompensation beschleunigt werden und effizienter erfolgen.

In einer Weiterbildung der Erfindung ist es vorgesehen, dass das Maximum des Effektivwerts der Boost-Funktion innerhalb von maximal 25 ms, bevorzugt maximal 20 ms vorliegt, und die Boost-Funktion innerhalb von maximal 120 ms, bevorzugt maximal 35 ms auf maximal 10% des Betrags des Maximums des Effektivwerts der Steuergröße, vorzugsweise des statischen Stroms, abklingt.

Dadurch kann die Kompensation effizienter erfolgen und durch die zeitliche Begrenzung bei der Erzeugung der Boost-Funktion Strom gespart werden.

Die erfindungsgemäße Aufgabe wird auch durch ein entsprechendes Verfahren gelöst.

Die Erfindung wird nachfolgend anhand eines in den beigeschlossenen Zeichnungen dargestellten Ausführungsbeispiels näher erläutert. In den Zeichnungen zeigt:

Fig. 1       vereinfachtes Nullersatzschaltbild eines Drei-Phasensystems,

Fig. 2       ein Ersatzschaltbild eines Drei-Phasensystems für das Beispiel gemäß der Fig. 1,

Fig. 3-5     Beispiele für Strom- und Spannungsverläufe ohne Boost-Funktion,

Fig. 6-8     Beispiele für Strom- und Spannungsverläufe mit Boost-Funktion,

Fig. 9       zeigt ein Beispiel für ein Blockschaltbild zur Erzeugung eines Kompensations- bzw. Einspeisestroms.

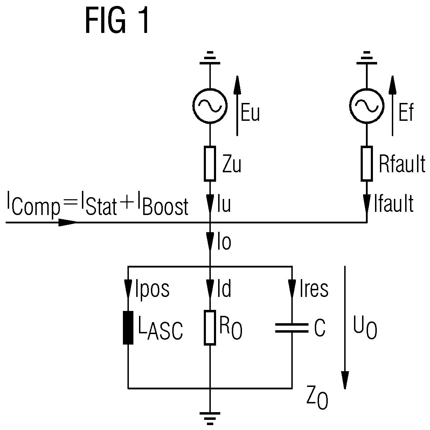

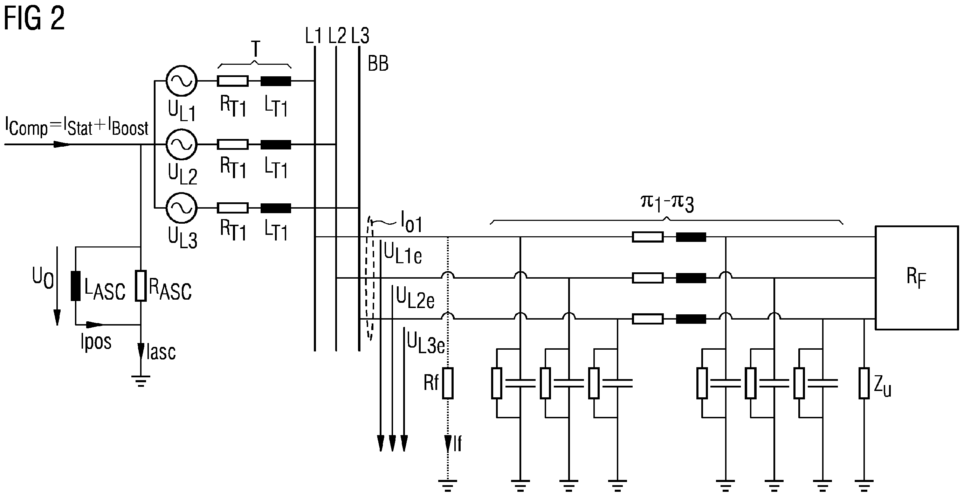

**Fig. 1** zeigt ein Ausführungsbeispiel der Erfindung mit einem vereinfachten Null-Ersatzschaltbild eines Drehstromnetzes bei Vorliegen eines, an einer Phase vorliegenden Erdschlusses, **Fig. 2** ein dementsprechendes Ersatzschaltbild eines Drei-Phasensystems mit einem Abgang.

Von einem Drehstrom-Transformator $T$ mit einer Sternschaltung der Phasen ist lediglich die Sekundärseite in den Figuren gezeigt.

Der Erdschluss kann durch eine treibende Fehlerspannung $E_f$ und einen Fehlerwiderstand $R_f$ beschrieben werden kann.

Ferner ist eine Netz-Asymmetrie dargestellt, welche hauptsächlich durch unterschiedliche Leiter - Erde Kapazitäten der drei Phasen gebildet wird. Im Nullersatzschaltbild wird der diese Unsymmetrie darstellende Unsymmetrie-Strom $I_u$ über die treibende Unsymmetrie-Spannung $E_u$ und der Unsymmetrie-Impedanz $Z_u$ dargestellt.

Die treibende Fehlerspannung $E_f$ erzeugt durch einen Fehlerwiderstand, welcher durch den Erdschluss gebildet sein kann, einen Fehler-Strom $I_f$

Zur Kompensation des kapazitiven Fehler-Stroms $I_f$ aufgrund des Erdschlusses ist der Sternpunkt des Netzes mittels einer Erdschluß-Löschspule $L_{ASC}$ (engl. "arc suppression coil") (Petersen-Spule) geerdet.

Die im Ersatzschaltbild eingezeichnete Netzimpedanz $Z_0$ wird durch die Parallelschaltung eines ohmschen Ersatzwiderstands $R_0$ für die gesamten Netzverluste, inklusive der Verluste der Erdschluß-Löschspule $L_{ASC}$, der Netzkapazität $C$ (Leitungskapazität) und der Induktivität der Erdschlusslöschspule gebildet.

Der Ersatzwiderstand $R_0$ bestimmt einen Dämpfungsstrom $I_D$.

Die Impedanz der Erdschluß-Löschspule $L_{ASC}$ und damit die Höhe eines induktiven Kompensationsstromes kann direkt durch Verstellen des Luftspaltes im Eisenkreis der Erdschluß-Löschspule verändert werden, oder die Sekundärseite der Erdschluß-Löschspule $L_{ASC}$ wird mit einer Induktivität, einem Kondensator oder einer definierten Stromeinspeisung beschaltet, und/oder es kann der Sternpunkt oder eine der drei Phasen mit einem ohmschen Widerstand, einer Induktivität, einem Kondensator oder einer definierten Stromeinspeisung beschaltet werden. Derartige Maßnahmen bzw. Einrichtungen sind dem Fachmann bekannt, sodass sie nicht naher erläutert oder dargestellt werden müssen.

Hier ist der Nachteil einer "statischen" Kompensation im Stand der Technik erkennbar.

Die Spulenposition kann über eine Positionsmessung mittels Potentiometer ermittelt werden. Daraus resultiert ein Spulenstrom $I_{pos}$.

Die Abstimmung der Erdschluß-Löschspule $L_{ASC}$ erfolgt im Normalbetrieb des Netzes (fehlerfreier Netzzustand), wobei die Erdschluß-Löschspule $L_{ASC}$ so eingestellt wird, dass der induktive Strom durch die Erdschluß-Löschspule $L_{ASC}$ dem kapazitiven Strom über die Netzkapazität (Resonanz-Strom $I_{res}$) entspricht.

In der Praxis kann für ein gelöschtes Netz jedoch ohne aktive Reststromkompensation in Normalbetrieb eine geringe Überkompensation bzw. Unterkompensation eingestellt sein. Dies kann durch Einstellung eines Stromes $I_{pos}$ erfolgen, welcher von der Position des Tauchkerns Erdschluß-Löschspule abhängt.

Bei einer aktiven Reststromkompensation kann es sinnvoll sein, genau auf eine Resonanz ($I_{pos} = I_{res}$) abzustimmen.

Bei einer exakten Abstimmung entspricht die Netzimpedanz $Z_0 = R_0$, das heißt es liegt ein Maximum der Impedanz des Parallelschwingkreises ($L_{ASC}$, $R_o$, $C$) vor, und der Strom über die Fehlerstelle wird ohne Reststromkompensation minimal.

Auch bei exakter Abstimmung ist eine vollständige Kompensation des Fehlerstromes mit der Löschspule allein nicht möglich, da ohmsche Verluste durch die Anordnung nicht kompensiert werden können.

Diese Verluste können mittels aktiver Reststromkompensation, das heißt aktiver Stromeinspeisung mit einem Kompensationsstrom $I_{Comp}(t)$, erfolgen.

Der Kompensationsstrom $I_{comp}(t)$ setzt sich aus einem statischen Strom $I_{stat}(t)$ und einem Boost-Strom $I_{Boost}(t)$ zusammen:

$$I_{Comp}(t) = I_{Stat}(t) + I_{Boost}(t)$$

Der statische Strom $I_{stat}(t)$ wird während des Abstimmvorgangs im Normalbetrieb ermittelt. Dabei werden alle Parameter des vereinfachten Nullersatzschaltbildes ermittelt.

Damit kann für den Fall eines Erdschlusses in Phase L1, L2 oder L3 der Einspeisestrom zur vollständigen Kompensation des Fehlerstromes ermittelt werden.

An der Erdschluß-Löschimpedanz $Z_0$ tritt eine komplexe Verlagerungsspannung $U_0$ auf und durch die Netzimpedanz $Z_0$ fließt ein Verlagerungsstrom $I_0$.

Der Unsymmetrie-Strom $I_u$, der Fehler-Strom $I_f$ und der Kompensations- bzw. Verlagerungsstrom $I_0$ fließen am Sternpunkt des Dreiphasennetzes zusammen.

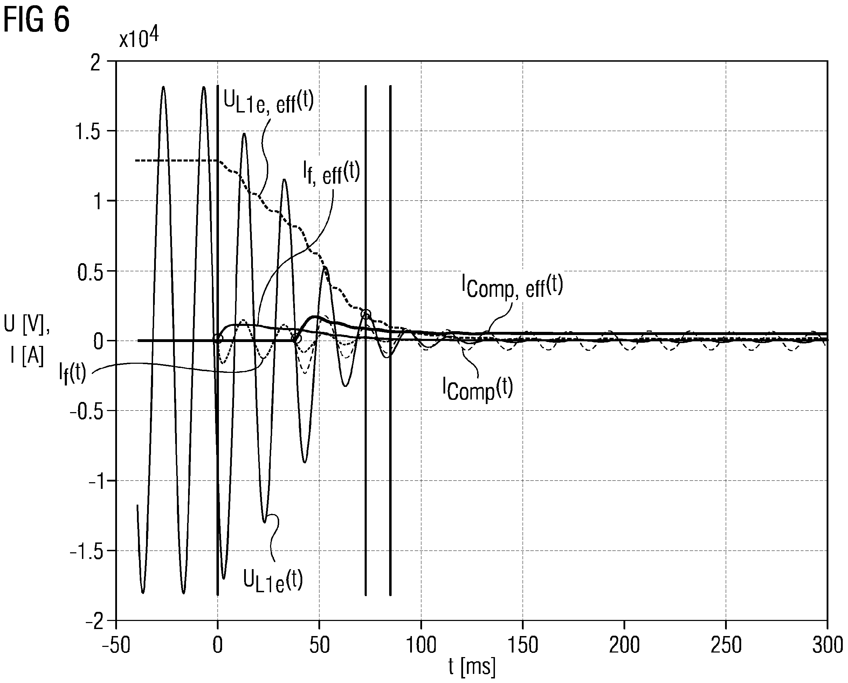

Ferner wird am Sternpunkt der Boost-Strom $I_{Boost}(t)$ von einer Umrichter-Schaltung, wie beispielsweise gemäß Fig. 6, eingespeist, welcher durch folgenden Zusammenhang bestimmt werden kann:

$$I_{Boost}(t) = \frac{U_{Lxe}(t)}{R_{Boost}(t)} = U_{Lxe}(t) \cdot Y_{Boost}(t)$$

Der Boost-Leitwert $Y_{Boost}$ kann beispielsweise so festgelegt werden, dass er einen maximalen Strom begrenzt, welchen die verwendete Umrichter-Schaltung noch unterstützt.

Der Boost-Strom $I_{Boost}(t)$ kann ein Strom sein, welcher der fehlerhaften Phase - Erdspannung proportional ist, und daher mit abnehmender Spannung $U_{Lxe}(t)$ mit $x = 1, 2, 3$ ebenfalls abnimmt.

Alternativ könnte beispielweise temporär eine Verdopplung des Kompensationsstrom erfolgen.

Der Boost-Leitwert $Y_{Boost}$ kann für einen gewählten Zeitbereich, wie beispielsweise 20 ms, 40 ms oder 120 ms konstant sein. Allgemein ist dies jedoch kein Erfordernis und der Boost-Leitwert $Y_{Boost}(t)$ kann daher auch zeitvariant sein.

Die erfindungsgemäße Kompensation erfolgt in drei Schritten:

1. Grundkompensation im gelöschten Netz: Kapazitive Leitungsströme werden im gelöschten Netz durch einen induktiven Strom mittels einer Petersen-Spule kompensiert.

Die Abstimmung des Netzes erfolgt im fehlerfreien Zustand, wobei bei optimaler Einstellung der Petersen-Spule der induktive Strom dem kapazitiven Null-Strom des Netzes entspricht.

Im einpoligen Erdschlussfall würde mit dieser Maßnahme nur mehr ein Wirkstrom über die Fehlerstelle fließen, was in vielen Fällen schon zum Verlöschen eines Erdschlusses, beispielsweise durch einen Lichtbogen, ausreicht.

Bei einer Überkompensation ($I_{pos} > I_{res}$) oder einer Unterkompensation ($I_{pos} < I_{res}$) würde zusätzlich zum Wirkanteil im Fehler-Strom $I_f$ ein induktiver oder kapazitiver Blindstrom auftreten.

Der Wirkanteil des Fehler-Strom $I_f$ kann durch die "passive" Petersen-Spule nicht kompensiert werden, jedoch mittels einer "aktiven" Reststromkompensation.

2. Einspeisung des statischen Stroms $I_{stat}(t)$: die aktive Reststromkompensation speist diesen Strom in den Sternpunkt des Drei-Phasentransformators ein, beispielsweise über eine Leistungs-Hilfswicklung der Petersen-Spule.

Der statische Strom $I_{stat}(t)$ wirkt dem Fehlerstrom entgegen, wodurch der Wirkanteil, und bei Über- oder Unterkompensation auch ein Blindanteil, im Fehlerstrom reduziert, beziehungsweise im optimalen Fall sogar auf vollständig kompensiert wird.

Die Einspeisung des statischen Stroms $I_{stat}(t)$ kann die Fehlerstelle vollständig entlasten.

Das Drei-Phasensystem reagiert auf diese Kompensation derart, dass sich die Verlagerungsspannung $U_0$ erhöht und die Phasen-Erdspannung ($U_{L1e}$ bei Erdschluss in Phase L1, $U_{L2e}$ bei Erdschluss in Phase L2, $U_{L3e}$ bei Erdschluss in Phase L3) der erdschlussbehafteten Phase verringert.

Bei Erdschlüssen, die sehr nahe der Sammelschiene, das heißt nahe am Transformator liegen und die Längsimpedanz von Sammelschiene bis zur Fehlerstelle vernachlässigbar klein ist, entspricht die Spannung $U_{L1e}$ (bzw. $U_{L2e}$, $U_{L3e}$) der Spannung an der Fehlerstelle.

Sofern die Spannung an der Fehlerstelle, das heißt die Spannung der Phase gegen Erde bei einpoligem Erdschluss, im optimalen Fall gegen 0 V geht, so wird auch der Fehlerstrom auf 0A reduziert.

Das Drei-Phasensystem kann jedoch nicht sprunghaft auf den statischen Strom $I_{stat}(t)$ reagieren, da eine Umladung der Leiter - Erde Kapazitäten erfolgen muss.

Diese Umladung ist abhängig von der Netzzeitkonstante des Netzes im fehlerfreien Zustand, und vom Erdschlusswiderstand.

Die Umladung erfolgt für sehr niederohmige Erdschlüsse sehr schnell, für Erdschlüsse mit einem höheren Widerstand entsprechend langsamer.

3. Einspeisung des Boost-Stroms $I_{Boost}(t)$: die aktive Reststromkompensation speist diesen Strom in den Sternpunkt des Drei-Phasentransformators ein.

Zur Beschleunigung des Umlade-Vorganges wird zusätzlich der Boost-Stroms $I_{Boost}(t)$ zum statischen Strom $I_{stat}(t)$

im Sternpunkt eingespeist.

Dies führt zu einer schnelleren Reduktion der Spannung $U_{L1e}$ (bzw. $U_{L2e}$, $U_{L3e}$) und damit zu einer entsprechend schnelleren Reduktion der Spannung an der Fehlerstelle Der Dreiphasen-Transformator $T$ setzt die einer Erzeuger- bzw. Quellen-Spannungen $U_{L1}$, $U_{L2}$, $U_{L3}$ zu den Netz-Spannungen $U_{L1e}$, $U_{L2e}$ und $U_{L3e}$ um, welche über eine Stromschiene BB (engl. "bus bar") für die Phasen L1-L3 verteilt werden.

Zur Abbildung eines realen Transformators sind die Innen-Impedanzen des Transformators in Form von Leitungswiderständen $R_{T1}$-$R_{T3}$ und Induktivitäten $L_{T1}$-$L_{T3}$ berücksichtigt.

Für jede der Netzleitungen der einzelnen Phasen L1-L3 ist ein Ersatzschaltbild in Form von $\Pi$-Gliedern $\Pi_1$-$\Pi_3$ für Leitungsimpedanzen mit Leitungs-Induktivitäten, Netz-Kapazitäten und Leitungswiderständen dargestellt, sowie ein abschließendes Last-Netzwerk RF1.

Zusätzlich soll eine Asymmetrie-Impedanz $Z_u$ die Netzunsymmetrie, in der Zeichnung beispielhaft an der Phase L3, darstellen.

Ein Fehlerstrom $I_f$ fließt durch einen Fehlerwiderstand $R_f$.

Im fehlerfreien Netz erfolgt die Bestimmung alle Parameter des vereinfachten Nullersatzschaltbildes mittels einer Abstimmung der Löschspule. Dadurch kann der statische Einspeisestrom $I_{stat}(t)$ zur vollständigen Kompensation des Fehlerstromes im Fall eines Erdschlusses in Phase L1, L2 oder L3 ermittelt werden.

Eine Mess- und Steuervorrichtung 1 ist vorgesehen und dazu eingerichtet, die Netzspannung $U_{L1e}$, $U_{L2e}$, $U_{L3e}$ zu erfassen und dabei eine auftretende Leitungsstörung $I_f$, beispielsweise durch Ermittlung eines Fehlerwiderstands $R_f$ zu erkennen und eine Steuergröße zur Kompensation der Leitungsstörung zu bestimmen.

Ferner ist eine Umrichter-Schaltung 2 vorgesehen und dazu eingerichtet, aus der Steuergröße einen Steuerstrom $I_{comp}$ zu erzeugen und zur Kompensation der Leitungsstörung $I_f$ im Sternpunkt des Transformators $T$ einzuspeisen.

Die Mess- und Steuervorrichtung 1 außerdem dazu eingerichtet, einen Boost-Leitwert $Y_{Boost}$ zu bestimmen, daraus eine Boost-Funktion zu ermitteln, einen entsprechenden Boost-Strom $I_{Boost}$ zu erzeugen und im Sternpunkt des Transformators $T$ einzuspeisen.

Die fehlerhafte Phase und der entsprechende Fehlerwiderstand $R_f$ können durch die Lage des Sternpunkts im dreiphasigen Mittel- oder Hochspannungsnetz ermittelt werden, wie dem Fachmann bekannt.

Die Mess- und Steuervorrichtung 1 ist dazu eingerichtet, die Netzspannungen $U_{L1e}$, $U_{L2e}$, $U_{L3e}$ mit einer Abtastrate von beispielswiese 10000 Abtastungen pro Sekunde oder auch darüber zu erfassen.

Die Umrichter-Schaltung 2 ist dazu eingerichtet, die Steuergröße mit einer Abtastrate von beispielsweise 10000 Abtastungen pro Sekunde oder auch darüber zu erzeugen.

Die Einspeisung des Steuerstroms $I_{Comp}$ bzw. Boost-Stroms $I_{Boost}$ erfolgt im Sternpunkt des Spannungsversorgungsnetzes.

Es kann vorgesehen sein, dass der Boost-Strom $I_{Boost}$ durch die Größe der maximalen Stromstärke begrenzt wird, die sich aus der Leistungsfähigkeit der verwendeten elektronischen Komponenten in der Umrichter-Schaltung ergibt.

Die Umrichter-Schaltung 2 entspricht einem Frequenzumrichter, also einem Stromrichter, der eine in der Frequenz und Amplitude veränderbare Wechselspannung bzw. einen Wechselstrom für die Kompensation generiert, und welcher in den Sternpunkt des Drehstromnetzes eingespeist wird, wie vorher erläutert. Derartige Umrichter mit hoher zeitlicher Auflösung, wie mit über 10000 Abtastungen pro Sekunde, sind dem Fachmann bekannt.

Die Mess- und Steuervorrichtung dient der Erfassung eines Fehlerstroms an den Phasen L1-L3 und berechnet die Amplitude und Phase des gewünschten Kompensationsstromes.

Derartige Mess- und Steuervorrichtung auf Mikroprozessor-Basis mit hoher zeitlicher Auflösung (10k Abtastungen pro Sekunde) sind dem Fachmann bekannt.

Die Mess- und Steuervorrichtung verbindet gemeinsam mit der Umrichter-Schaltung die Netzspannungs-Seite mit den Netzspannungen $U_{L1e}$, $U_{L2e}$, $U_{L3e}$ des Transformators $T$ mit der Quellenspannungs-Seite mit den Quellenspannungen $U_{L1}$, $U_{L2}$, $U_{L3}$ durch Anwendung des entsprechenden Kompensationsstroms, das heißt des Steuerstroms $I_{Comp}$ bzw. Boost-Stroms $I_{Boost}$.

Ein Verfahren zur Kompensation einer auf einem dreiphasigen Spannungsversorgungsnetz auftretenden Leitungsstörung $I_f$ kann dementsprechend angegeben werden.

Dabei wird eine Netzspannung $U_{L1e}$, $U_{L2e}$, $U_{L3e}$ erfasst, eine dabei auftretende Leitungsstörung $I_f$, beispielsweise durch Ermittlung eines Fehlerwiderstands $R_f$ erkannt, eine Steuergröße zur Kompensation der Leitungsstörung bestimmt, und aus der Steuergröße ein Steuerstrom $I_{Comp}$ erzeugt und zur Kompensation der Leitungsstörung $I_f$ im Sternpunkt des Transformators $T$ des Spannungsversorgungsnetzes eingespeist.

Der Boost-Leitwert $Y_{Boost}$ wird bestimmt, daraus eine Boost-Funktion ermittelt, ein entsprechender Boost-Strom $I_{Boost}$ erzeugt und im Sternpunkt des Transformators $T$ eingespeist.

Die Boost-Funktion weist ein Maximum von 20%, bevorzugt 50%, besonders bevorzugt 100% oder 200% des Betrags des Maximums des Effektivwerts der Steuergröße auf.

Das Maximum des Effektivwerts der Boost-Funktion liegt innerhalb von maximal 25 ms, bevorzugt maximal 20 ms vor, und die Boost-Funktion klingt innerhalb von maximal 120 ms, bevorzugt maximal 35 ms auf maximal 10% des Betrags des Maximums des Effektivwerts der Steuergröße, das heißt des statischen Stroms $I_{Stat}(t)$, ab.

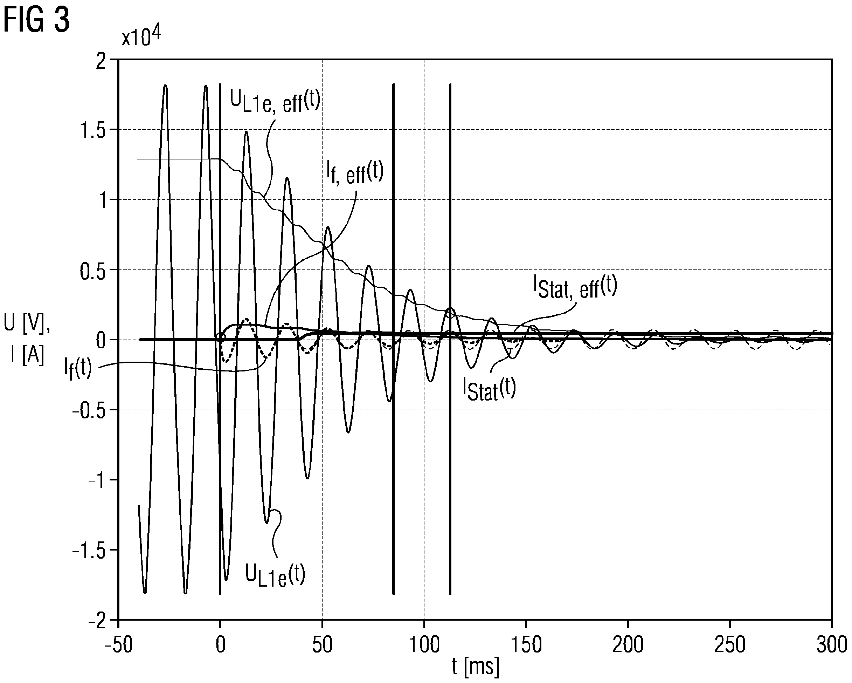

**Fig. 3** bis **Fig. 5** zeigen Darstellung von Strom- und Spannungen ohne Anwendung der Boost-Funktion.

Mit dem Index "eff" wird jeweils der Effektivwert einer jeweiligen Größe bezeichnet.

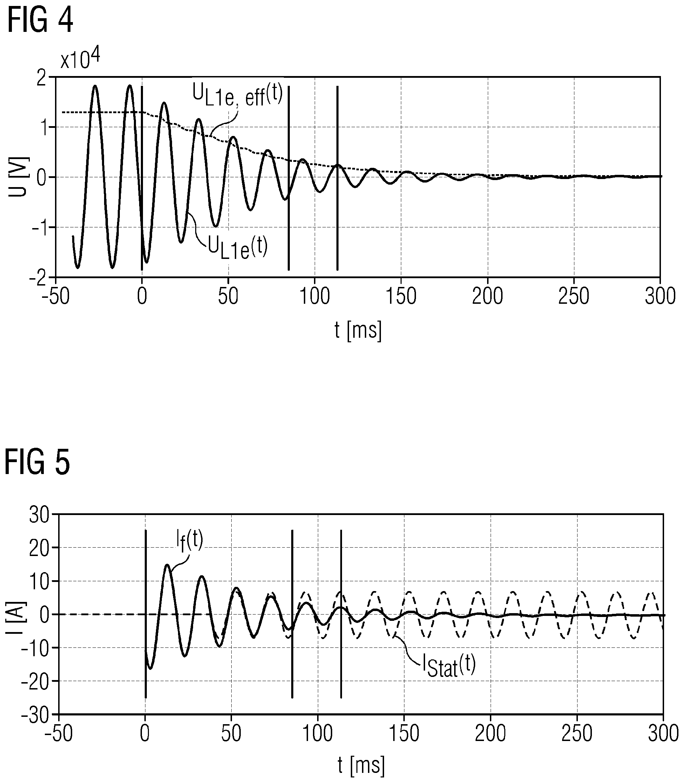

Fig. 4 und Fig. 5 sind vergrößerte Darstellungen der Fig. 3 zur verbesserten Erkennbarkeit.

Es ist die Netz-Spannung $U_{L1e}$ mit einem Scheitelwert von 18 kV und einem Effektivwert von ca. 12700 V erkennbar.

Zum Zeitpunkt 0 ms erfährt das Spannungsversorgungsnetz einen Fehlerstrom $I_f$ und die Netz-Spannung $U_{L1e}$ bricht ein. In der

Figur ist zusätzlich der Effektivwert des Fehlerstroms $I_f$ mit einer 100-fachen Skalierung ablesbar.

Zum Zeitpunkt ca. 40 ms wird der Einspeisestrom $I_{stat}(t)$ gemäß der konventionellen Art und Weise eine Erdschluß-Löschspule $L_{ASC}$ zu bestimmen, errechnet und angewandt, wie durch den Effektivwert des Einspeisestroms $I_{eci}$ mit einer 100-fachen Skalierung erkennbar ist.

Es ist erkennbar, dass es etwa 113 ms dauert, bis die Spannung unter 1900 V gesunken ist, wie es von Netzbetreibern gefordert wird.

Jedoch lautet die Forderung, dass dieses Spannungsziel innerhalb von 85 ms erreicht werden soll. Daher ist die dargestellte Kompensation nicht ausreichend schnell.

Netzbetreiber definieren beispielsweise einen LIF (engl. "low impedance fault") von beispielsweise 400 Ohm, bei welchem innerhalb von 85 ms die verbleibende Phase-Erdspannung der fehlerbehafteten Phase in einem 22 kV-Netz unter 1900V abgeklungen sein muss.

Die tatsächliche Netzzeitkonstante ist höher,

- je geringer die Verluste im Netz sind, das heißt je höher der Widerstand $R_0$ ist, und

- je höher der Fehlerwiderstand $R_f$ im einpoligen Erdschlussfall ist, und

- je größer der kapazitive Strom des Netzes ist.

Durch Einspeisung des "statischen" Kompensationsstromes $I_{stat}(t)$ kann der Fehlerstrom $I_f$ bis auf 0 A reduziert werden.

In diesem Beispiel wird davon ausgegangen, dass eine Einspeisung des Kompensationsstroms erst nach 40 ms erfolgt.

**Fig. 6** bis **Fig. 8** zeigen Darstellungen von Strom- und Spannungen mit Anwendung der Boost-Funktion.

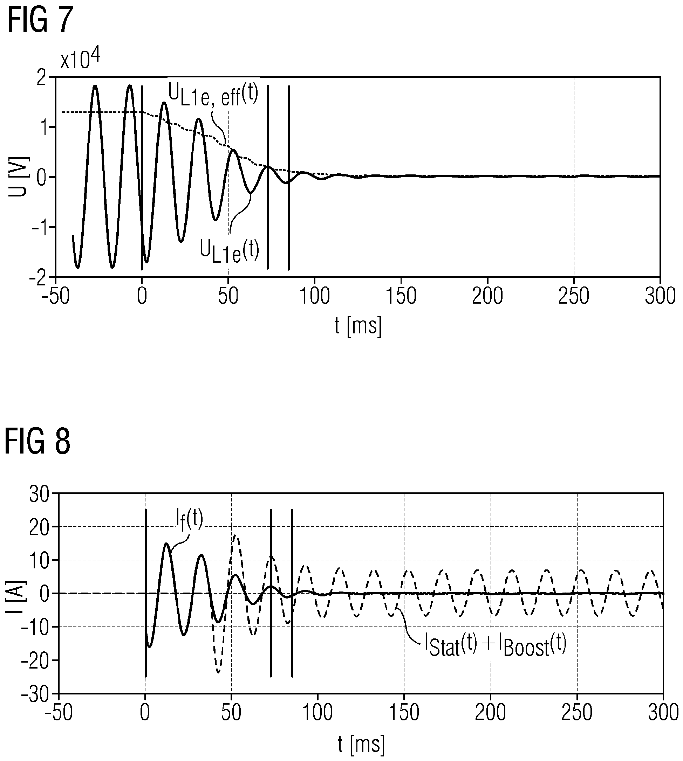

Fig. 7 und Fig. 8 sind vergrößerte Darstellungen der Fig. 6 zur verbesserten Erkennbarkeit.

Durch die temporäre Erhöhung des Einspeisestromes, das heiß mittels Boost-Funktion wird die Spannung $U_{L1e}$, und damit die Spannung an der Fehlerstelle, schneller reduziert.

Es ist erkennbar, dass der Einspeisestrom $I_{Comp}(t)$ größer als der reine statische Strom $I_{stat}(t)$ ist, und dann in weiterer Folge abnimmt, jeweils auf den Effektivwert bezogen.

Mit anderen Worten sinkt der Boost-Strom $I_{Boost}(t)$ gegen Null, da sich die Spannung $U_{L1e}$ auch gegen Null reduziert und es verbleibt der Einspeisestrom $I_{stat}(t)$.

Die Darstellung entspricht zudem den Ausführungen der vorhergehenden Figur.

Jedoch verläuft der Einspeisestroms $I_{stat}(t)$ um die Boost-Funktion $I_{Boost}(t)$ vergrößert, sodass eine schnellere Kompensation des Fehlers erreicht wird.

Es ist daher erkennbar, dass bereits nach 73 ms die Spannung $U_{L1}$ die Spannung unter 1900 V so rasch gesunken ist, sodass die vorher genannten Anforderungen von Netzbetreibern erfüllt werden können.

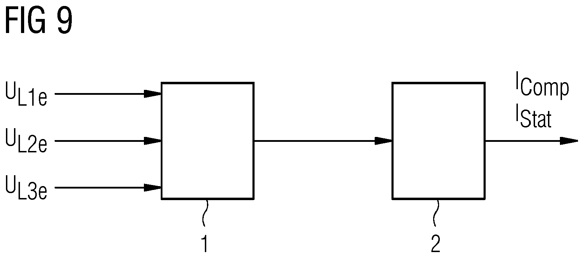

**Fig. 9** zeigt ein Blockschaltbild einer Schaltung zur Erzeugung des Kompensations- bzw. Einspeisestroms $I_{stat}(t)$ und/oder $I_{Boost}(t)$, ausgehend von Fig. 2 mit den Netz-Spannungen $U_{L1e}$, $U_{L2e}$, $U_{L3e}$, wobei in diesem Beispiel die Phase $L1$ einen niederohmigen Erdschluss-Fehler aufweist.

Mit einer derartigen Anordnung kann auch der Kompensations- bzw. Einspeisestroms $I_{stat}(t)$ und/oder $I_{Boost}(t)$ erzeugt gemäß der Fig. 1 werden.

**Bezugszeichenliste:**

| | |
|---|---|
| 1 | Mess- und Steuervorrichtung |
| 2 | Umrichter |

| $BB$ | Stromschiene (engl. "bus bar") |
| --- | --- |
| $C$ | Netzkapazität |
| $E_f$ | treibende Fehlerspannung |
| $E\mu$ | treibende Unsymmetriespannung |
| $I_{ASC}$ | Strom über die Erdlöschspule-Impedanz |
| $I_d$ | Dämpfungsstrom |
| $I_{comp}$ | Einspeisestrom |
| $I_f$ | Strom über die Fehlerstelle |
| $I_{o1}$ | Nullstrom für Abgang 1 |
| $I_{pos}$ | Spulenposition |
| $I_{res}$ | Resonanzpunkt des Netzes |
| $I_u$ | Unsymmetriestrom |
| $L1, L2, L3$ | Phase |
| $L_{ASC}$ | Induktivität der Erdlöschspule-Spule (ASC, engl "arc suppresion coil") |
| $L_{T1}, L_{T2}, L_{T3}, R_{T1}, R_{T2}, R_{T3}$ | Innenimpedanz des Transformators |
| $\Pi_1, \Pi_2, \Pi_3$ | Π-Glieder als Phasen-Innenimpedanz des Transformators |
| $R_0$ | Ersatzwiderstand |
| $R_{ASC}$ | Ersatzwiderstand der Erdlöschspule-Spule |
| $R_f$ | Fehlerwiderstand, Erdschlusswiderstand |
| $T$ | Transformator |
| $U_0$ | Verlagerungsspannung, Nullspannung |
| $U_{L1}, U_{L2}, U_{L3}$ | Erzeuger-Spannung Phase gegen Erde |
| $U_{L1e}, U_{L2e}, U_{L3e}$ | Netz-Spannung Phase gegen Erde |
| $Z_u$ | Impedanz Unsymmetrie |

**Patentansprüche**

1. Vorrichtung zur Kompensation einer auf einem dreiphasigen Spannungsversorgungsnetz auftretenden Leitungsstörung ($I_f$), umfassend einen Transformator ($T$) mit einem Sternpunkt, welcher dazu eingerichtet ist, eine Netzspannung ($U_{L1e}, U_{L2e}, U_{L3e}$) und dadurch eine Verlagerungsspannung ($U_0$) zu erzeugen, und ferner eine Mess- und Steuervorrichtung (1) vorgesehen ist, welche dazu eingerichtet ist, die Netzspannung ($U_{L1e}, U_{L2e}, U_{L3e}$) oder die Verlagerungsspannung ($U_0$) zu erfassen und dabei eine auftretende Leitungsstörung ($I_f$) zu erkennen und eine Steuergröße zur Kompensation der Leitungsstörung zu bestimmen, und ferner eine Umrichter-Schaltung (2) vorgesehen ist, welche dazu eingerichtet ist, aus der Steuergröße einen Steuerstrom ($I_{comp}$) zu erzeugen und zur Kompensation der Leitungsstörung ($I_f$) im Sternpunkt des Transformators ($T$) einzuspeisen,
   **dadurch gekennzeichnet, dass** die Mess- und Steuervorrichtung (1) ferner dazu eingerichtet ist, einen Boost-Leitwert ($Y_{Boost}$) zu bestimmen, daraus eine Boost-Funktion zu ermitteln, einen entsprechenden Boost-Strom ($I_{Boost}$) zu erzeugen und im Sternpunkt des Transformators ($T$) einzuspeisen.

2. Vorrichtung nach dem vorhergehenden Anspruch, wobei die Boost-Funktion ein Maximum von 20%, bevorzugt 50%, besonders bevorzugt 100% oder 200% des Betrags des Maximums des Effektivwerts der Steuergröße aufweist.

3. Vorrichtung nach dem vorhergehenden Anspruch, wobei das Maximum des Effektivwerts der Boost-Funktion innerhalb von maximal 25 ms, bevorzugt maximal 20 ms vorliegt, und die Boost-Funktion innerhalb von maximal 120 ms, bevorzugt maximal 35 ms auf maximal 10% des Betrags des Maximums des Effektivwerts der Steuergröße abklingt.

4. Verfahren zur Kompensation einer auf einem dreiphasigen Spannungsversorgungsnetz auftretenden Leitungsstörung ($I_f$), wobei eine Netzspannung ($U_{L1e}, U_{L2e}, U_{L3e}$) oder eine Verlagerungsspannung ($U_0$) erfasst wird, eine dabei auftretende Leitungsstörung ($I_f$) erkannt wird, eine Steuergröße zur Kompensation der Leitungsstörung bestimmt wird, und aus der Steuergröße ein Steuerstrom ($I_{Comp}$) erzeugt und zur Kompensation der Leitungsstörung ($I_f$) im Sternpunkt des Transformators ($T$) des Spannungsversorgungsnetzes eingespeist wird,
   **dadurch gekennzeichnet, dass** ein Boost-Leitwert ($Y_{Boost}$) bestimmt wird, daraus eine Boost-Funktion ermittelt wird, ein entsprechender Boost-Strom ($I_{Boost}$) erzeugt wird und im Sternpunkt des Transformators ($T$) eingespeist wird.

**5.** Verfahren nach dem vorhergehenden Anspruch, wobei die Boost-Funktion ein Maximum von 20%, bevorzugt 50%, besonders bevorzugt 100% oder 200% des Betrags des Maximums des Effektivwerts der Steuergröße aufweist.

**6.** Verfahren nach dem vorhergehenden Anspruch, wobei das Maximum des Effektivwerts der Boost-Funktion innerhalb von maximal 25 ms, bevorzugt maximal 20 ms vorliegt, und die Boost-Funktion innerhalb von maximal 120 ms, bevorzugt maximal 35 ms auf maximal 10% des Betrags des Maximums des Effektivwerts der Steuergröße abklingt.

FIG 1

FIG 2

$R_F$

$Z_u$

$\pi_1$-$\pi_3$

$I_{o1}$

$U_{L1e}$

$U_{L2e}$

$U_{L3e}$

$R_f$

$I_f$

BB

L1 L2 L3

T

$R_{T1}$  $L_{T1}$

$U_{L1}$

$U_{L2}$

$U_{L3}$

$I_{Comp}=I_{Stat}+I_{Boost}$

$R_{ASC}$

$I_{asc}$

$L_{ASC}$

$I_{pos}$

$U_0$

FIG 3

EP 3 907 840 A1

## FIG 4

## FIG 5

FIG 6

FIG 7

FIG 8

FIG 9

$U_{L1e}$ →

$U_{L2e}$ →

$U_{L3e}$ →

1

2

$I_{Comp}$
$I_{Stat}$

**Europäisches Patentamt**
**European Patent Office**
**Office européen des brevets**

# EUROPÄISCHER RECHERCHENBERICHT

**Nummer der Anmeldung**

EP 20 17 3634

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2016 110420 A1 (ENBW ENERGIE BADEN-WÜRTTEMBERG AG [DE]) 7. Dezember 2017 (2017-12-07) * das ganze Dokument * ----- | 1-6 | INV. H02H9/08 |
| X | WO 02/15355 A2 (ADAPTIVE REGELSYSTEME GES M B [AT]; LEIKERMOSER ALBERT [AT]) 21. Februar 2002 (2002-02-21) * Seiten 8,9; Abbildung 2 * ----- | 1,4 | |

**RECHERCHIERTE SACHGEBIETE (IPC)**

H02H

Der vorliegende Recherchenbericht wurde für alle Patentansprüche erstellt

| Recherchenort | Abschlußdatum der Recherche | Prüfer |
|---|---|---|
| München | 2. Oktober 2020 | Trifonov, Antoniy |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 20 17 3634

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

02-10-2020

| Im Recherchenbericht angeführtes Patentdokument | Datum der Veröffentlichung | Mitglied(er) der Patentfamilie | Datum der Veröffentlichung |
|---|---|---|---|
| DE 102016110420 A1 | 07-12-2017 | DE 102016110420 A1<br>EP 3287796 A2 | 07-12-2017<br>28-02-2018 |
| WO 0215355 A2 | 21-02-2002 | AT 411937 B<br>AU 1212902 A<br>EP 1307753 A2<br>HU 0301630 A2<br>WO 0215355 A2 | 26-07-2004<br>25-02-2002<br>07-05-2003<br>28-08-2003<br>21-02-2002 |

Für nähere Einzelheiten zu diesem Anhang : siehe Amtsblatt des Europäischen Patentamts, Nr.12/82